(19) Europäisches Patentamt / European Patent Office / Office européen des brevets

(11) EP 2 222 042 A1

(12) **EUROPEAN PATENT APPLICATION**
published in accordance with Art. 153(4) EPC

(43) Date of publication:
25.08.2010 Bulletin 2010/34

(51) Int Cl.:
*H04L 27/00* (2006.01)

(21) Application number: 08854315.2

(22) Date of filing: 18.11.2008

(86) International application number:
PCT/JP2008/003367

(87) International publication number:
WO 2009/069263 (04.06.2009 Gazette 2009/23)

(84) Designated Contracting States:
AT BE BG CH CY CZ DE DK EE ES FI FR GB GR
HR HU IE IS IT LI LT LU LV MC MT NL NO PL PT
RO SE SI SK TR
Designated Extension States:
AL BA MK RS

(30) Priority: 28.11.2007 JP 2007307455

(71) Applicant: Panasonic Corporation
Kadoma-shi
Osaka 571-8501 (JP)
(72) Inventors:
• TAKANO, Haruka
c/o Panasonic Corporation, IPROC
Chuo-ku, Osaka-shi, Osaka 540-6207 (JP)
• SOGA, Shigeru
c/o Panasonic Corporation, IPROC
Chuo-ku, Osaka-shi, Osaka 540-6207 (JP)

(74) Representative: Grünecker, Kinkeldey,
Stockmair & Schwanhäusser
Anwaltssozietät
Leopoldstrasse 4
80802 München (DE)

(54) **DEMODULATION DEVICE, RECEPTION DEVICE, AND DEMODULATION METHOD**

(57)     A device mitigates reduction in reception performance caused by a harmonic component of a clock used for demodulation. The device includes a tuner performing frequency conversion by multiplying a received signal by a signal having a frequency corresponding to a frequency of a desired signal included in the received signal, and outputting the obtained frequency-converted signal; and a demodulation section generating a demodulated signal by demodulating the frequency-converted signal. The demodulation section operates in response to a master clock having a frequency corresponding to the frequency of the desired signal.

FIG.1

EP 2 222 042 A1

**Description**

TECHNICAL FIELD

The present invention relates to demodulators for demodulating digitally modulated signals and receivers including such a demodulator.

BACKGROUND ART

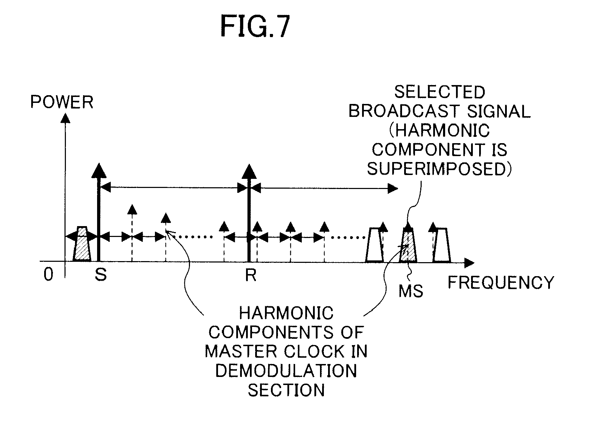

FIG. 7 is a spectrum diagram illustrating an example spectrum of a signal in a conventional demodulator. The demodulator includes a tuner selecting a broadcast signal and a demodulation section demodulating the broadcast signal selected at the tuner. The tuner multiplies a received signal by a signal having a frequency R (where R is a real number) for frequency conversion, and outputs the obtained IF signal to the demodulation section. The demodulation section operates in response to a master clock having a frequency S (where S is a real number). Since the frequency S is constant, the spectrum of the selected broadcast signal may be superimposed on a harmonic component (frequency MS where M is a natural number) of the clock. In this case, reception performance for the broadcast signal is reduced.

In order to address the problem, Patent Document 1 describes preparing two crystal oscillators having different oscillation frequencies, and selecting the crystal oscillator to be used in accordance with the frequency of a signal to be received.

A transport stream (TS) obtained by demodulating a digitally modulated signal may have a jitter (fluctuation of intervals of packets etc.). In order to compensate the jitter, Patent Document 2 describes selecting one of two clocks having different frequencies, and outputting a TS according to the selected clock.

Patent Document 3 describes a receiver, in which a tuner and a demodulation section shares a common crystal oscillator, thereby reducing the number of crystal oscillators.

PATENT DOCUMENT 1: Japanese Patent Publication No. 2004-56367
PATENT DOCUMENT 2: Japanese Patent Publication No. 2007-110184
PATENT DOCUMENT 3: Japanese Patent Publication No. H11-341376

SUMMARY OF THE INVENTION

TECHNICAL PROBLEM

However, Patent Document 1 describes switching between the two crystal oscillators, and thus, controls are complex if the jitter in the TS is to be compensated. In addition, since two crystal oscillators are needed for a demodulation section, the number of the components is increased, thereby increasing the cost of the demodulator.

In Patent Documents 2 and 3, since the clock frequency used at the demodulation section is constant, the reception performance may be reduced due to the effects of the harmonic components of the clock as described above.

It is an objective of the present invention to provide a demodulator mitigating reduction in reception performance caused by harmonic components of a clock used for demodulation.

SOLUTION TO THE PROBLEM

The demodulator according to an example embodiment of the present invention includes a tuner configured to perform frequency conversion by multiplying a received signal by a signal having a frequency corresponding to a frequency of a desired signal included in the received signal, a nd to output the obtained frequency-converted signal; and a demodulation section configured to generate a demodulated signal by demodulating the frequency-converted signal. The demodulation section operat es in response to a master clock having a frequency corresponding to the frequency of the desired signal.

With this configuration, the demodulation section operates in response to the master clock having the frequency corresponding to the frequency of the signal, which is used at the tuner, for frequency-converting the received signal. Therefore, a harmonic component of the master clock can be prevented from being superimposed on the spectrum of a signal to be selected.

Furthermore, the receiver according to an example embodiment of the present invention includes a demodulator, and an output section. The demodulator includes a tuner configured to perform frequency conversion by multiplying a received signal by a signal having a frequency corresponding to a frequency of a desired signal included in the received signal, and to output the obtained frequency-converted signal; and a demodulation section configured to generate a demodulated signal by demodulating the frequency-converted signal. The demodulation section operates in response to a master clock having a frequency corresponding to the frequency of the desired signal. The output section includes a display and a speaker, performs decoding of the demodulated signal generated at the demodulator, and performs display at the display and sound output from the speaker in accordance with the result.

This configuration realizes a receiver mitigating reduction in reception performance caused by a harmonic component of the master clock.

The demodulation method according to an example embodiment of the present invention includes the steps of performing frequency conversion by multiplying a received signal by a signal having a frequency corr esponding to a frequency of a desired signal included in the received signal, and demodulating the frequency-converted signal. The step of demodulating is performed in response to a master clock having a frequency corresponding to the frequency of the desired signal.

ADVANTAGES OF THE INVENTION

An example embodiment of the present invention mitigates reduction in reception performance caused by harmonic components of a master clock of a demodulation section. Since a reference signal can be shared between a tuner and a demodulation section, the number of components can be reduced and the circuit can be simplified. Furthermore, a jitter in a TS can be easily compensated, while avoiding the effects of the harmonic components of the master clock.

BRIEF DESCRIPTION OF THE DRAWINGS

[FIG. 1] FIG. 1 is a block diagram illustrating the configuration of a receiver according to an embodiment of the present invention.
[FIG. 2] FIG. 2 is a block diagram illustrating an example configuration of the demodulation clock recovery section in FIG. 1.
[FIG. 3] FIG. 3 is a block diagram illustrating an example configuration of a TS clock recovery section of FIG. 1.
[FIG. 4] FIG. 4 is a timing chart illustrating example signal waveforms in the demodulation clock recovery section in FIG. 2 and the TS clock recovery section in FIG. 3.
[FIG. 5] FIG. 5 is a spectrum diagram illustrating an example spectrum of the signal of the receiver in Fig. 1.
[FIG. 6] FIG. 6 is an illustration of an example sequence of data transmitted as an IF signal IFS.
[FIG. 7] FIG. 7 is a spectrum diagram illustrating an example spectrum of a signal in a conventional demodulator.

DESCRIPTION OF REFERENCE CHARACTERS

14   Demodulator
16   Output Section
30   Tuner
32   PLL
34   Frequency Divider
36   Multiplier
40   Demodulation Section
41   First Demodulation Stage
42   Second Demodulation Stage
44   FIFO Buffer
46   Demodulation Clock Recovery Section
48   TS Clock Recovery Section
52   Rate Information Processing Section

DESCRIPTION OF EMBODIMENTS

An embodiment of the present invention will be described hereinafter with reference to the drawings.

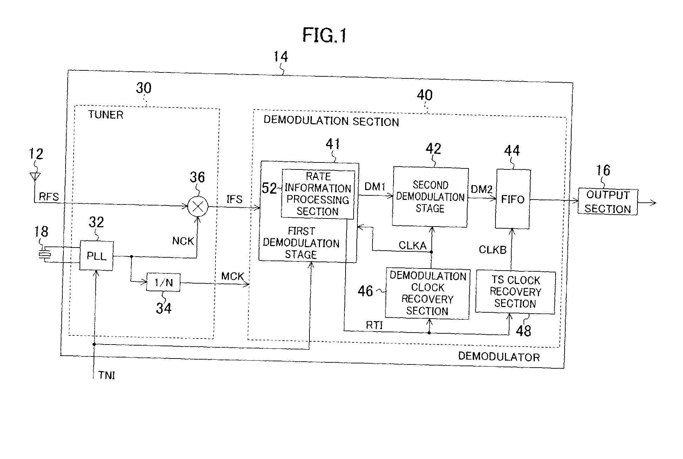

FIG. 1 is a block diagram illustrating the configuration of a receiver according to the embodiment of the present invention. The receiver of Fig. 1 includes an antenna 12, a demodulator 14, an output section 16, and a crystal oscillator 18. The demodulator 14 includes a tuner 30 and a demodulation section 40. The tuner 30 includes a phase locked loop (PLL) 32, a frequency divider 34, and a multiplier 36. The demodulation section 40 includes a first demodulation stage 41, a second demodulation stage 42, a first-in, first-out (FIFO) buffer 44, a demodulation clock recovery section 46, and a transport stream (TS) clock recovery section 48.

The antenna 12 receives a plurality of digitally modulated broadcast signals and supplies the signals to the multiplier 36 as a received signal RFS. The PLL 32 is coupled to the crystal oscillator 18. The PLL 32 generates a station selection clock NCK, as a variable frequency signal, having a frequency NF (where N is a natural number, and F is a real number) corresponding to station selection information TNI, which is input from the outside of the demodulator 14, using an almost constant oscillation frequency F0 of the crystal oscillator 18 as a reference. The frequency of the station selection clock NCK is a frequency corresponding to a frequency of a desired broadcast signal included in the received signal RFS. The station selection information TNI indicates how many times the frequency of the station selection clock NCK needs to be as high as the oscillation frequency F0 so that the desired broadcast signal can be obtained as a signal of an IF band after the frequency conversion at the multiplier 36.

The frequency divider 34 divides the frequency of the station selection clock NCK to generate a master clock MCK having a frequency F (a frequency of one-N th of the frequency of the station selection clock NCK), and outputs the master clock to the demodulation section 40. The multiplier 36 generates a signal having the same frequency as the station selection clock NCK, frequency-converts the received signal RFS in an RF band to an IF signal IFS in the IF band by multiplying the generated signal by the received signal RFS, and outputs the IF signal IFS to the demodulation section 40 as the obtained frequency-converted signal. The PLL 32 may output the clock having a frequency F to the demodulation section 40 as the master clock MCK.

The first demodulation stage 41 performs frequency conversion, cancellation of any DC component, quadrature detection and the like on the IF signal IFS, and outputs the obtained symbol value as a demodulated signal DM1. The first demodulation stage 41 includes a rate information processing section 52. The rate information processing section 52 obtains and outputs the result of the following equation.

(Rate Information RTI)

$$\text{(Rate Information RTI)}$$
$$= \text{(Symbol Rate of IF Signal IFS (or Demodulated Signal DM1)) / (Clock Rate of Master Clock MCK) / k) (where k is a natural number)... (1)}$$

The master clock MCK is provided to the demodulation clock recovery section 46 and the TS clock recovery section 48, unchanged or after being frequency-divided. The equation (1) shows the case where the ratio of the frequency of the clock provided to the demodulation clock recovery section 46 and the TS clock recovery section 48 to the frequency of the master clock MCK is 1/k. The rate information RTI is a value less than one.

In other words, the rate information RTI is represented by the following equation (2).

$$\text{(Rate Information RTI)}$$
$$= k \cdot \text{(Period of Master Clock MCK) / (Symbol Period of IF signal IFS (or Demodulated Signal DM1)) (where k is a natural number)...(2)}$$

The following is an example where k is one.

The demodulation clock recovery section 46 generates a demodulation clock CLKA based on the master clock MCK and the rate information RTI. The TS clock recovery section 48 generates as a clock for a TS output, a TS clock CLKB based on the master clock MCK and the rate information RTI. The TS clock recovery section 48 controls the frequency of the clock CLKB to be more constant than the frequency of the clock CLKA.

The first demodulation stage 41 operates in response to the clock CLKA. The second demodulation stage 42 performs equalization, demapping, error correction and the like on the demodulated signal DM1 in response to the clock CLKA, and outputs the obtained result to the FIFO buffer 44 as a demodulated signal DM2. The FIFO buffer 44 receives and stores the demodulated signal DM2, and outputs the stored values of the demodulated signal DM2 as a TS in response to the clock CLKB in the received order. Specifically, the demodulation section 40 generates the demodulated signal DM2 by demodulating the IF signal IFS, and outputs the signal as a TS.

If the IF signal IFS is a multicarrier signal such as an OFDM signal, the second demodulation stage 42 also performs fast Fourier transform (FFT). In this case, a sampling period of the FFT is used in the equation (2) instead of the symbol period.

The output section 16 includes a display and a speaker. The output section 16 separates image data, sound data, or other data from the TS output from the FIFO buffer 44, and performs decoding of the image and sound data (e.g., decoding of moving picture experts group (MPEG) coded data) to obtain the transmitted image data, sound data, or the like. The output section 16 displays the images at the display and outputs the sounds from the speaker in accordance with the obtained image and sound data.

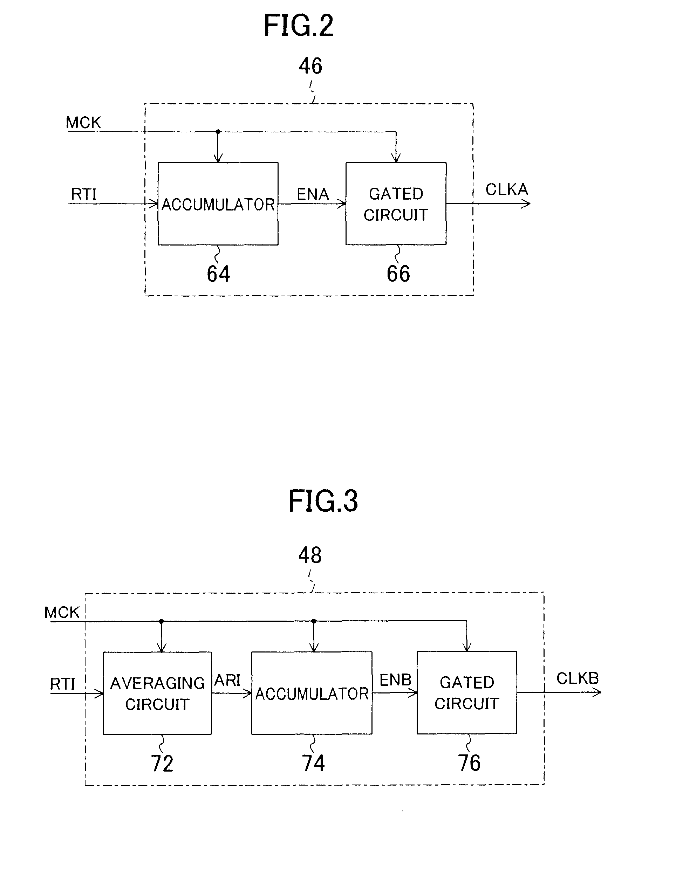

FIG. 2 is a block diagram illustrating an example configuration of the demodulation clock recovery section 46 in FIG. 1. The demodulation clock recovery section 46 includes an accumulator 64 and a gated circuit 66. The accumulator 64 synchronizes with the master clock MCK, accumulates the rate information RTI, and outputs to the gated circuit 66, an enable signal ENA corresponding to the accumulated result.

The accumulator 64 outputs high potential (H) as the enable signal ENA when the accumulated result is one or more, and outputs low potential (L) as the enable signal ENA when the accumulated result is less than one. In addition, the accumulator 64 subtracts one from the accumulated result when the accumulated result is one or more. The gated circuit 66 outputs the master clock MCK as the clock CLKA only during the period in which the enable signal ENA is at the "H" level. Therefore, the clock CLKA includes pulses synchronizing with the master clock MCK at a frequency corresponding to the rate information RTI.

FIG. 3 is a block diagram illustrating an example configuration of the TS clock recovery section 48 in FIG. 1. The TS clock recovery section 48 includes an averaging circuit 72, an accumulator 74, and a gated circuit 76. The averaging circuit 72 averages the rate information RTI, and outputs the obtained average rate information ARI to the accumulator 74. The accumulator 74 synchronizes with the master clock MCK, accumulates the average rate information ARI, and outputs to the gated circuit 76, an enable signal ENB corresponding to the accumulated result.

The accumulator 74 outputs "H" as the enable signal ENB when the accumulated result is one or more, and outputs "L" as the enable signal ENB when the accumulated result is less than one. In addition, the accumulator 74 subtracts one from the accumulated result when the accumulated result is one or more. The gated circuit 76 outputs the master clock MCK as the clock CLKB only during the period in which the enable signal ENB is at the "H" level. Therefore, the clock CLKB includes pulses synchronizing with the master clock MCK at a frequency corresponding to the average rate information ARI.

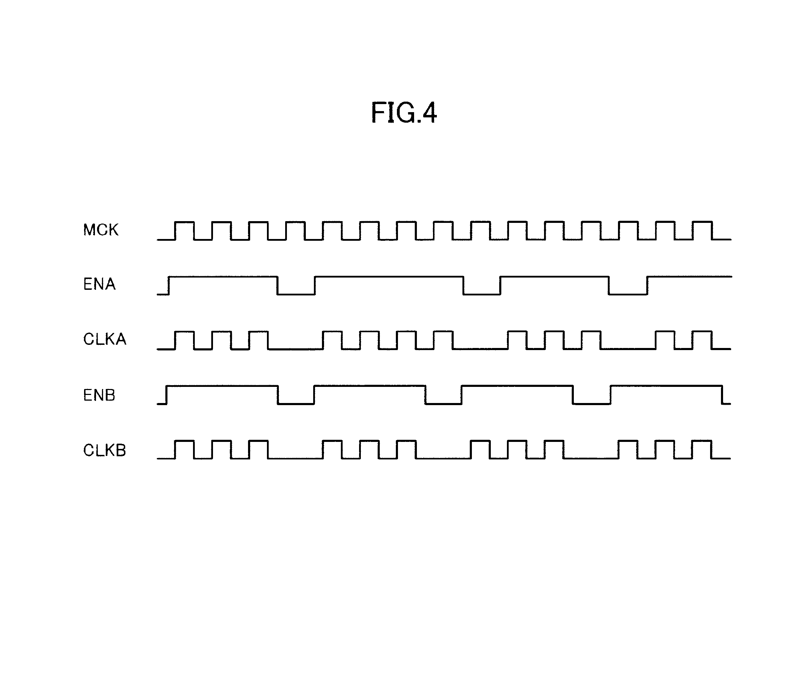

FIG. 4 is a timing chart illustrating example signal waveforms in the demodulation clock recovery section 46 in FIG. 2 and the TS clock recovery section 48 in FIG. 3. If the rate information RTI fluctuates, e.g., in the range from 0.7 to 0.8 due to fading or the like, the enable signal ENA is, for example, as shown in FIG. 4. In FIG. 4, the gated circuit 66 outputs three pulses of the master clock MCK as the clock CLKA, does not output the next pulse, outputs four pulses, and then, does not output the next pulse.

FIG. 4 illustrates the case where the average rate information ARI output from the averaging circuit 72 is 0.75. Since the average rate information A RI holds an almost constant value, the enable signal ENB is, for example, as shown in FIG. 4. Then, the gated circuit 76 almost steadily outputs three pulses per four pulses of the master clock MCK as the clock CLKB.

As such, since the TS clock recovery section 48 includes the averaging circuit 72, and generates the clock CLKB using the average rate information ARI, the frequency of the clock CLKB is more constant than that of the clock CLKA. Therefore, the jitter of the TS output from the FIFO buffer 44 can be reduced.

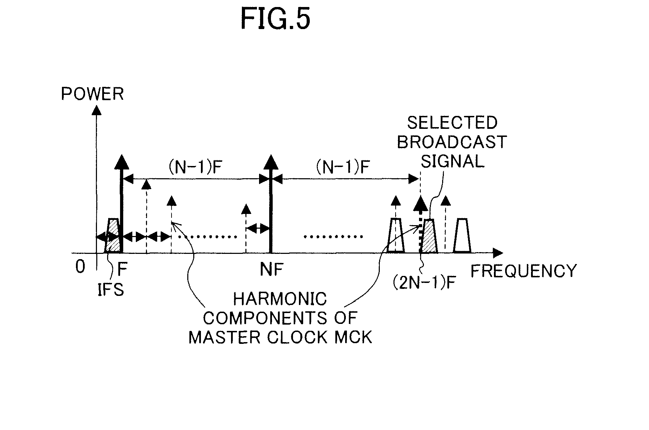

FIG. 5 is a spectrum diagram illustrating an example spectrum of the signal in the demodulator of FIG. 1. The PLL 32 controls the frequency NF of the station selection clock NCK in accordance with the station selection information TNI so that the spectrum of the IF signal IFS is lower than the frequency F of the master clock MCK. Thus, the spectrum of the selected broadcast signal is always higher than the frequency (2N-1)F of a harmonic component of the master clock MCK, which is closest to the spectrum. (Since the difference between the frequency NF of the signal multiplied by the received signal RFS at the multiplier 36 and the frequency F of the master clock MCK is (N-1)F, the frequency of the harmonic component of the master clock MCK which is closest to the spectrum of the selected broadcast signal is $2 \times (N-1)F + F = (2N-1)F$). Therefore, the harmonic component of the master clock MCK is not superimposed on the selected broadcast signal.

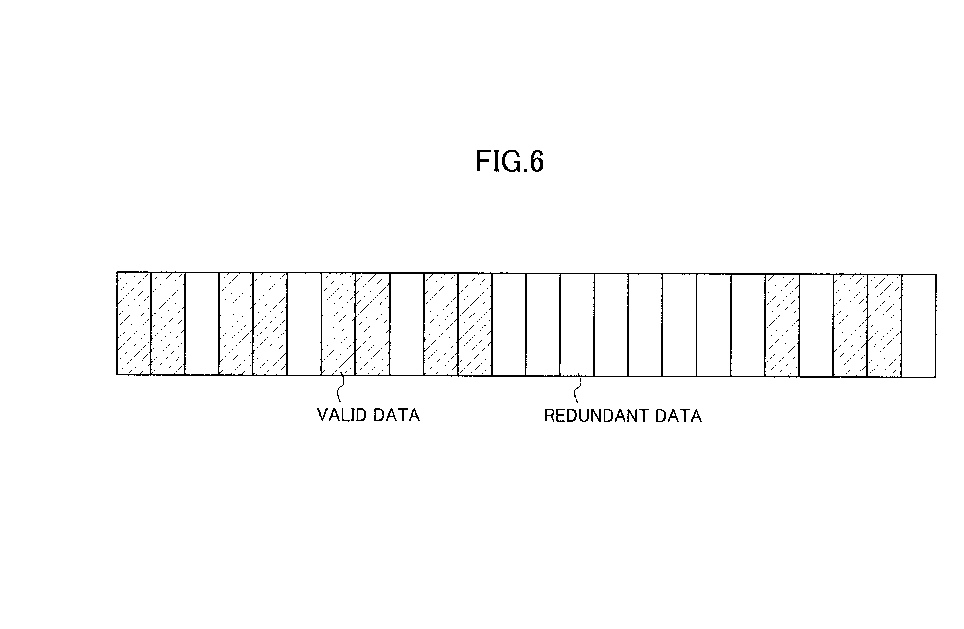

FIG. 6 is an illustration of an example sequence of data transmitted by an IF signal IFS. The data transmitted by the IF signal IFS includes data for synchronization and the like. The data will be unnecessary after the clock synchronization, and thus, will be deleted in the second demodulation stage 42. FIG. 6 shows redundant data to be deleted, and valid data to be output to the outside of the demodulator 14.

Since only the valid data of the data in FIG. 6 is output as a TS, the pulse number of the clock CLKB may be a number obtained by multiplying the pulse number of the clock CLKA by the proportion of the valid data. The rate information RTI may be averaged after the averaging circuit 72 multiplies the ratio of the transmission rate of the TS to the transmission rate of the IF signal IFS by the rate information RTI. This enables the TS to be efficiently output particularly when the proportion of the valid data is not an integer reciprocal.

As described above, according to this embodiment, the frequency F of the master clock MCK in the demodulation section 40 changes in accordance with the frequency of the selected broadcast signal. Thus, the selected broadcast signal is not affected by the harmonic component of the master clock MCK, thereby mitigating reduction in reception performance caused by the harmonic component of the master clock MCK.

Furthermore, since the FIFO buffer 44 outputs the TS in response to the clock CLKB generated based on the average rate information ARI, the TS packets are equally spaced to reduce the jitter in the TS. Since the rate information detected based on the master clock MCK is used, there is no need to perform another type of control even if the frequency of the master clock MCK changes. This easily realizes compensation of the jitter in the TS at low costs.

While an example has been described where the multiplier 36 frequency-converts the received signal RFS to the IF signal IFS, the multiplier 36 may frequency-convert the received signal RFS to a baseband signal.

While an example has been described where the demodulator 14 receives the broadcast signal, the demodulator 14 may receive a signal for other communications, or a signal transmitted through a wired connection.

Furthermore, the TS clock recovery section 48 may monitor the capacity consumed in the FIFO buffer 44. The section may increase the value of the average rate information ARI when the capacity consumed in the FIFO buffer 44 is a predetermined threshold or more, and may decrease the value of the average rate information ARI when the capacity consumed in the FIFO buffer 44 is less than the predetermined threshold.

While an example has been described where the FIFO buffer 44 is located at the last stage of the demodulation section 40, the FIFO buffer 44 may be at other locations within the demodulation section 40.

Furthermore, the TS clock recovery section 48 may be provided with a clock having a frequency higher than the frequency of the clock provided to the demodulation clock recovery section 46. For example, the demodulation clock recovery section 46 is provided with a clock having one-quarter of the frequency obtained by dividing the frequency of the master clock MCK, instead of the master clock MCK, and the TS clock recovery section 48 is provided with the unchanged master clock MCK. This reduces fluctuations in the timing at which the TS is output compared to the case where the TS clock recovery section 48 is provided with the same clock as the demodulation clock recovery section 46, thereby reducing the jitter of the TS.

INDUSTRIAL APPLICABILITY

As described above, the present invention mitigates reduction in reception performance caused by a harmonic component of a clock used for demodulation, and is thus useful for a demodulator, a receiver, and the like.

**Claims**

1. A demodulator comprising:

   a tuner configured to perform frequency conversion by multiplying a received signal by a signal having a frequency corresponding to a frequency of a desired signal included in the received signal, and to output the obtained frequency-converted signal; and
   a demodulation section configured to generate a demodulated signal by demodulating the frequency-converted signal, wherein
   the demodulation section operates in response to a master clock having a frequency corresponding to the frequency of the desired signal.

2. The demodulator of claim 1, wherein
   the demodulation section includes
   a first demodulation stage configured to detect the frequency-converted signal,
   a second demodulation stage configured to perform demapping and error correction on the detected signal, and to output the signal as the demodulated signal, and
   a demodulation clock recovery section configured to generate a demodulation clock,
   the first demodulation stage includes a rate information processing section configured to obtain a value corresponding to the ratio of the period of the master clock to a symbol period of the frequency-converted signal as rate information,
   the demodulation clock recovery section generates a clock having pulses synchronizing with the master clock at a frequency corresponding to the rate information as the demodulation clock, and

the second demodulation stage operates in response to the demodulation clock.

3. The demodulator of claim 2, wherein
   the demodulation section further includes
   a transport stream clock recovery section configured to generate a clock having pulses synchronizing with the master clock at a frequency corresponding to the rate information as a transport stream clock, and
   a first-in, first-out (FIFO) buffer configured to store the demodulated signal, and to output the stored demodulated signal as a transport stream in response to the transport stream clock in stored order.

4. The demodulator of claim 3, wherein
   the clock recovery section for the transport stream averages the rate information, and generates a clock having pulses synchronizing with the master clock at a frequency corresponding to the obtained average rate information as the transport stream clock.

5. The demodulator of claim 3, wherein
   the clock recovery section for the transport stream multiplies the rate information by the ratio of the transmission rate of the frequency-converted signal to the transmission rate of the transport stream output from the FIFO buffer, and generates a clock having pulses synchronizing with the master clock at a frequency corresponding to the obtained result as the transport stream clock.

6. A receiver comprising:

   a demodulator; and
   an output section, wherein
   the demodulator includes
   a tuner configured to perform frequency conversion by multiplying a received signal by a signal having a frequency corresponding to a frequency of a desired signal included in the received signal, and to output the obtained frequency-converted signal, and
   a demodulation section configured to generate a demodulated signal by demodulating the frequency-converted signal,
   the demodulation section operates in response to a master clock having a frequency corresponding to the frequency of the desired signal, and
   the output section includes a display and a speaker, performs decoding of the demodulated signal generated at the demodulator, and performs display at the display and sound output from the speaker according to the result.

7. A demodulation method comprising the steps of:

   performing frequency conversion by multiplying a received signal by a signal having a frequency corresponding to a frequency of a desired signal included in the received signal; and
   demodulating the frequency-converted signal, wherein
   the step of demodulating is performed in response to a master clock having a frequency corresponding to the frequency of the desired signal.

## FIG.1

# FIG.2

46

MCK

RTI → ACCUMULATOR — ENA → GATED CIRCUIT → CLKA

64

66

# FIG.3

48

MCK

RTI → AVERAGING CIRCUIT — ARI → ACCUMULATOR — ENB → GATED CIRCUIT → CLKB

72

74

76

# FIG.4

MCK

ENA

CLKA

ENB

CLKB

EP 2 222 042 A1

# FIG.5

# FIG.6

VALID DATA          REDUNDANT DATA

# FIG.7

POWER

SELECTED
BROADCAST SIGNAL
(HARMONIC
COMPONENT IS
SUPERIMPOSED)

0    S    R    MS    FREQUENCY

HARMONIC
COMPONENTS OF
MASTER CLOCK IN
DEMODULATION
SECTION

| INTERNATIONAL SEARCH REPORT | International application No. |
|---|---|
| | PCT/JP2008/003367 |

A.   CLASSIFICATION OF SUBJECT MATTER
*H04L27/00* (2006.01) i

According to International Patent Classification (IPC) or to both national classification and IPC

B.   FIELDS SEARCHED

Minimum documentation searched (classification system followed by classification symbols)
H04L7/00, 27/00

Documentation searched other than minimum documentation to the extent that such documents are included in the fields searched
Jitsuyo Shinan Koho           1922-1996   Jitsuyo Shinan Toroku Koho   1996-2008
Kokai Jitsuyo Shinan Koho   1971-2008   Toroku Jitsuyo Shinan Koho   1994-2008

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
|---|---|---|
| X<br>A | JP 11-032359 A   (Kokusai Electric Co., Ltd.),<br>02 February, 1999 (02.02.99),<br>Par. Nos. [0017] to [0031]; Figs. 1, 2<br>(Family: none) | 1,6,7<br>2-5 |
| X<br>A | JP 2005-354242 A   (Japan Radio Co., Ltd.),<br>22 December, 2005 (22.12.05),<br>Par. No. [0038]; Fig. 1<br>(Family: none) | 1,6,7<br>2-5 |
| X<br>A | JP 3105381 B2   (Mitsubishi Electric Corp.),<br>30 October, 2000 (30.10.00),<br>Par. No. [0025]; Fig. 4<br>& JP 7-79264 A | 1,6,7<br>2-5 |

| ☒ | Further documents are listed in the continuation of Box C. | ☐ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 17 December, 2008 (17.12.08) | 06 January, 2009 (06.01.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

14

**INTERNATIONAL SEARCH REPORT**

International application No.

PCT/JP2008/003367

C (Continuation).   DOCUMENTS CONSIDERED TO BE RELEVANT

| Category* | Citation of document, with indication, where appropriate, of the relevant passages | Relevant to claim No. |
|---|---|---|
| A | JP 09-018463 A  (Kokusai Electric Co., Ltd.), 17 January, 1997 (17.01.97), Full text (Family: none) | 2 |
| A | JP 2004-356858 A  (Victor Company Of Japan, Ltd.), 16 December, 2004 (16.12.04), Full text (Family: none) | 3-5 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004056367 A
- JP 2007110184 A
- JP H11341376 B